Europäisches Patentamt

European Patent Office

Office européen des brevets

(19)

(11) Publication number: **0 032 043**
**B1**

(12) **EUROPEAN PATENT SPECIFICATION**

(45) Date of publication of patent specification: **01.08.84**

(21) Application number: **80304669.7**

(22) Date of filing: **22.12.80**

(51) Int. Cl.³: **H 03 K  19/013,**
**H 03 K  19/088**

(54) Transistor-transistor logic circuit.

(30) Priority: **27.12.79 JP  169184/79**

(43) Date of publication of application:
**15.07.81 Bulletin 81/28**

(45) Publication of the grant of the patent:
**01.08.84 Bulletin 84/31**

(84) Designated Contracting States:
**DE FR GB NL**

(56) References cited:
**GB - A -  859 045**
**US - A - 3 244 910**
**US - A - 3 411 045**
**US - A - 3 439 186**
**US - A - 3 506 846**

**IBM TECHNICAL DISCLOSURE BULLETIN, vol.
14, no. 6, November 1971, New York US
GERSBACH: "Speedup of TTL Circuits", page
1685**

(73) Proprietor: **FUJITSU LIMITED**
**1015, Kamikodanaka Nakahara-ku
Kawasaki-shi Kanagawa 211 (JP)**

(72) Inventor: **Enomoto, Hiromu**
**1-15-1225, Kawara-cho
Saiwai-ku, Kawasaki-shi Kawagawa 210 (JP)**
Inventor: **Mitono, Yoshiharu**
**1-14-12, Sakuragaoka
Setagaya-ku Tokyo. 156 (JP)**
Inventor: **Yasuda, Yasushi**
**92-2, Ohmaru
Inagi-shi Tokyo 192-02 (JP)**
Inventor: **Ohta, Hiroshi**
**2646-3, Eda-cho
Midori-ku, Yokohama-shi Kanagawa 227 (JP)**
Inventor: **Imaizumi, Taketo**
**449, Koueki
Sue-cho, Kasuya-gun Fukuoka 811-21 (JP)**

(74) Representative: **Bedggood, Guy Stuart et al,
Haseltine Lake & Co. Hazlitt House 28
Southampton Buildings Chancery Lane
London WC2A 1AT (GB)**

Courier Press, Leamington Spa, England.

## Description

This invention relates to transistor-tramsistor logic circuits (hereinafter referred to as TTL circuits), and more particularly, although not exclusively, to an open-collector type TTL circuit which operates at high speed.

As is well known, a logic IC (Integrated Circuit) capable of operating at high speed, and being a type of an integrated circuit of a large scale, can be obtained by employing TTL circuits. Accordingly, TTL circuits are used in a variety of small to medium scale digital ICs.

As described above, a logic IC which uses TTL circuits is capable of performing high-speed operation. However, due to the recent demand for an even faster highspeed data processing, a logic IC which is capable of operating at an even higher speed is desirable. Therefore, the realisation of a TTL circuit which is capable of performing an even faster high speed operation is highly desired.

IBM Technical Disclosure Bulletin, Vol. 14, No. 6, November 1971, page 1685, in an article by J. E. Gersbach, discloses a TTL circuit having input means for receiving an input signal, a phase-splitting transistor having its base connected to the input means and its collector connected to a power source via a resistor, and an output transistor having its base connected to the emitter of the phase-splitting transistor and to deliver an output to a capacitor load from its collector. It discloses a solution to the problem of reducing the turn-on time of the output transistor by using a further transistor, properly disposed in relation to other elements of the circuit, for driving the base of the output transistor.

GB—A—859 045 discloses the use of capacitors for speeding up circuit operations. In each case the capacitor is connected directly to a terminal of an output transistor.

According to the present invention, there is provided a transistor-transistor logic circuit comprising:

an input means for receiving an input logic signal;

a phase-splitting transistor having its base connected to the input means and its collector connected for receiving a power source potential (Vcc) of the circuit via a resistor, and

an output transistor having its base connected to the emitter of said phase-splitting transistor, and being arranged to supply on its collector an output logic signal responsive to said input logic signal;

characterised in that the circuit further comprises a capacitative element having one terminal connected to the collector of said phase-splitting transistor, and another terminal connected to a point of predetermined potential, operable to reduce the turn-on time of the output transistor.

Due to the provision of the capacitive element the turn-on-time of the output transistor is reduced, and preferred embodiments of the invention operate at a higher operating speed, compared to conventional TTL circuits.

Preferred embodiments of the invention aim to provide a TTL circuit which is of an open-collector type, capable of operating at high speed. In such circuits, the turn-off-time of the output transistor may be unchanged, and only the turn-on-time reduced, compared to conventional circuits.

Other embodiments of the invention aim to provide a TTL circuit which is of a totem pole type, capable of operating at high speed. In such circuits, the turn-off-time of the output transistor may be increased, but its turn-on-time reduced. The turn-on-time and the turn-off-time of the output transistor can be made equal, by selecting a suitable capacitance for the capacitive element which is connected to the collector of the phase-splitting transistor.

For a better understanding of the invention and to show how the same may be carried into effect, reference will be made, by way of example only, with reference to the accompanying diagrammatic drawings in which:

Fig. 1 is a circuit diagram showing a first embodiment of a TTL circuit according to the present invention;

Figs. 2A and 2B are circuit diagrams respectively showing modified embodiments of the essential part of the TTL circuit of Fig. 1;

Fig. 3 is a graph showing a first operational characteristic of the TTL circuit of Fig. 1, wherein a capacitance versus operation time characteristic is shown;

Fig. 4 is a graph showing a second operational characteristic of the TTL circuit of Fig. 1, wherein an emitter current versus elapsed time characteristic is shown;

Fig. 5 is a circuit diagram showing a further embodiment of a TTL circuit according to the present invention; and

Figs. 6A and 6B are graphs respectively showing capacitance versus operation time characteristics of the further embodiment.

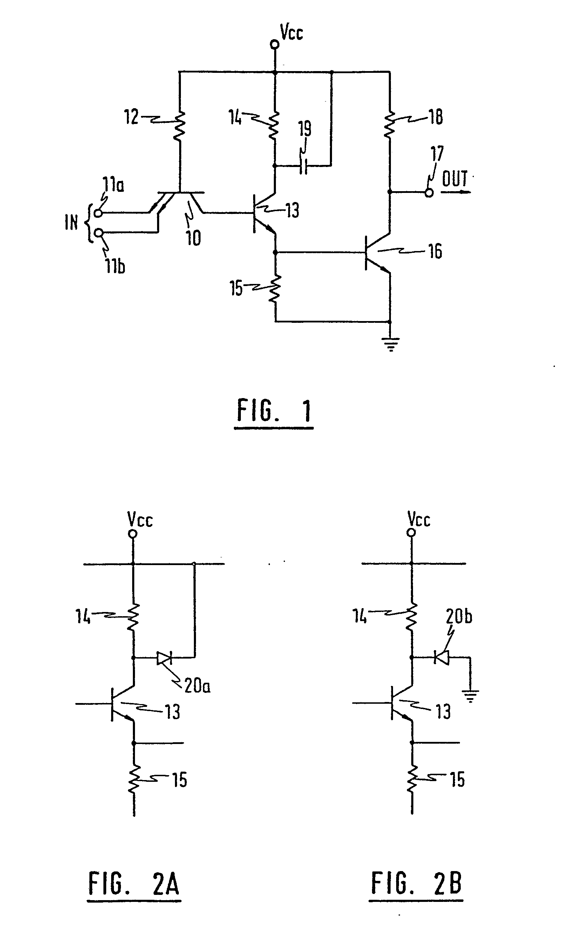

Fig. 1 is a circuit diagram showing a first embodiment of a TTL circuit of the present invention, of an open-collector type. An input transistor 10 comprises two emitters connected to input terminals 11a and 11b which are fed with an input logic signal IN. The base of the input transistor 10 is connected to a voltage source Vcc through a base resistor 12, and its collector is connected to the base of a phase-splitting transistor 13. The collector of the transistor 13 is connected to the voltage source Vcc through a collector resistor 14, and its emitter is connected to the base of an output transistor 16 as well as to ground through a resistor 15. The emitter of the transistor 16 is grounded. The collector of the transistor 16 is only connected to an output terminal 17 which supplies an output logic signal OUT as output, to form a so-called open-collector. However, upon use of this circuit, the collector of the transistor 16 is connected to the voltage source Vcc through a collector resistor 18. Accordingly, the above circuit elements as a whole construct a two-input-NAND TTL circuit.

A capacitor 19 which is used as the capacitive element which forms the essential part of the circuit of the present invention, is connected in parallel with the resistor 14, between the collector of the transistor 13 and the voltage source Vcc. This capacitor 19 is provided to reduce the turn-on-time of the output transistor, as will be described in the following.

The operation of the circuit of the above construction will now be described. When an input logic signal IN of high level is applied to the input terminals 11a and 11b of the input transistor 10, a base current flows to the phase-splitting transistor 13, to turn the transistor 13 ON. Accompanied by this turning ON of the transistor 13, the output transistor 16 also becomes ON.

The above base current which turns the transistor 16 ON is equal to (I1+I2—I3), where I1 is the current which flows to the transistor 16 through the resistor 12 and the transistors 10 and 13, I2 is the current which flows to the transistor 16 through the resistor 14 and the transistor 13, and I3 is the bypassed current which flows through the resistor 15. Hence, the turn-on-time (that is, the propagation delay time tpHL from the high level to low level) of the output transistor 16 is determined by the magnitude of this current (I1+I2—I3).

During the period in which the transistor 13 is OFF, the capacitor 19 is fully charged up to the voltage Vcc of the voltage source. And, when the transistor 13 is turned ON, the collector impedance of the transistor 13 is greatly decreased. Accordingly, all the electrical charge which was charged in the capacitor 19, is added and superposed at once with the above circuit I2. Accordingly, the base current during the transient period in which the output transistor is turned ON, instantly becomes of a relatively high current. As a result, the turn-on-time of the output transistor 16 becomes quite short, and the operational speed of the TTL circuit is substantially increased.

The capacitor 19 which has one of its terminal connected to the collector of the transistor 13, is connected to the voltage source Vcc at its other terminal. In the present embodiment, however, the connection of the capacitor 19 is not limited to the above connection, and can be a connection in which the other terminal of the capacitor 19 is connected to ground. Moreover, this other terminal of the capacitor 19 can be connected to an intermediate voltage Vm between the voltage Vcc and ground potential. The point is, as long as the capacitor 19 is charged up to the source voltage Vcc at one of its terminals during the period in which the phase-splitting transistor 13 is OFF, the other terminal of the capacitor 19 can be of any connection.

Furthermore, the stray capacitance formed between the substrates of a semiconductor device, a transistor, a resistor, or a diode can be used as the capacitor 19. In the case where a diode or a transistor is used as the capacitor 19, the capacitance of the corresponding PN-junction diode is used. However, since the capacitance of the PN-junction generally comprises a large voltage dependency factor, it is desirable to keep the capacitance at a maximum value, by making the electrical potential at the two terminals equal. Therefore, in this case, the anode of a diode 20a is connected to the collector of the transistor 13, and the cathode of the diode 20a is connected to the voltage source Vcc, as shown in Figure 2A. On the other hand, in the case where one terminal of the diode is grounded, the cathode and the anode of a diode 20b are respectively connected to the collector of the transistor 12 and ground, as shown in Figure 2B.

Generally, when the turn-on-time tpHL of the circuit operation is reduced, this reducing of the turn-on-time accompanies a reverse effect in which the turn-off-time tpLH is increased. However, in the present embodiment, the turn-off-time of the output transistor 16 does not increase. The reason why the turn-off-time of the transistor 16 does not increase is that, when the transistor 13 is turned ON, the transistor 16 is also turned ON. However, the turn-off-time of the transistor 16 is independent of the construction of the circuit at the collector side of the transistor 13, and simply only dependent on the time the electrical charge charged at the base of the transistor 16 takes to discharge through the base resistor 15. Hence, according to the present embodiment of the invention, only the turn-on-time of the transistor 16 is reduced without accompanying increase in the turn-off-time of the transistor 16.

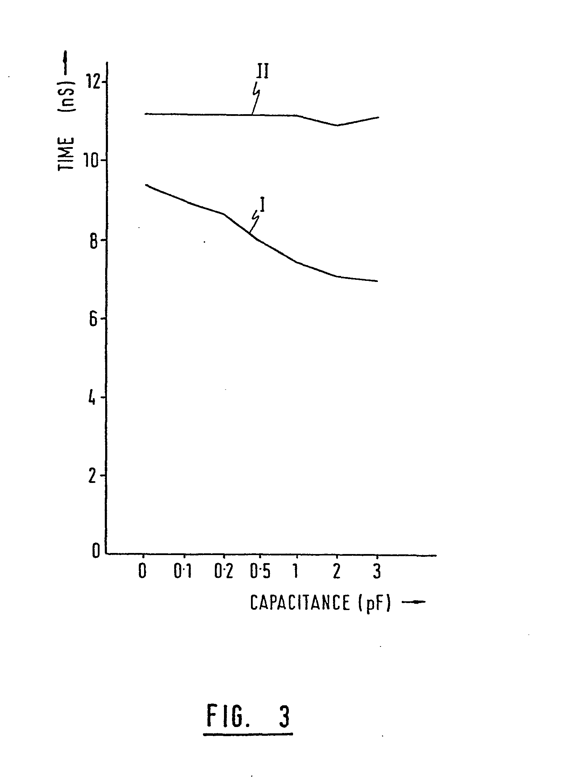

A first operational characteristic of the TTL circuit of Figure 1 is shown in Figure 3. In Figure 3, the horizontal-axis indicates the capacitance of the capacitor 19 in pico-farads (pF), and the vertical-axis indicates the turn-on and turn-off times T in nano-seconds (ns). A curve I shows the turn-on-time tpHL. As clearly seen from the curve I, as the capacitance increases, the turn-on-time is reduced, and the operational speed is accordingly increased. A curve II shows the turn-off-time tpLH. As clearly seen from the curve II, the turn-off-time is substantially constant no matter what the capacitance is, for the reasons described above.

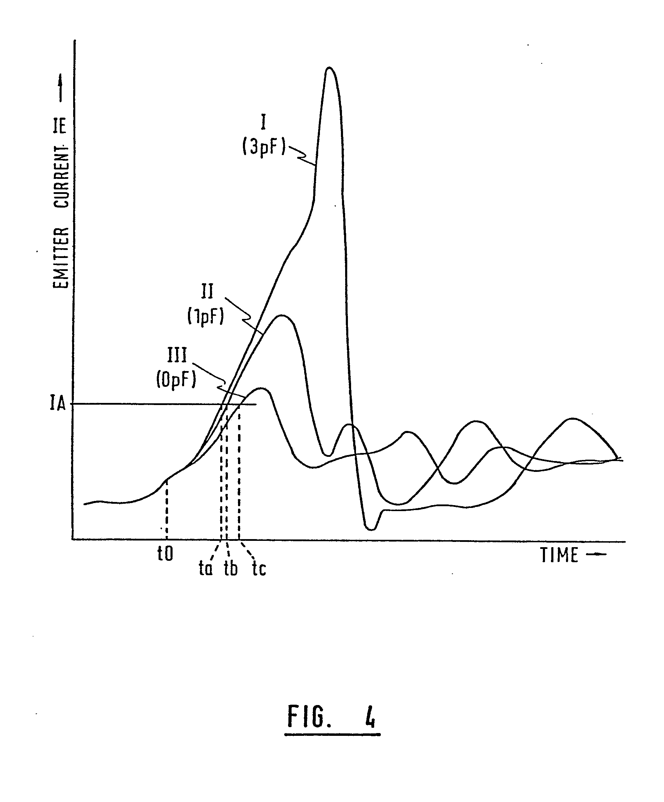

A second operational characteristic of the TTL circuit of Figure 1 is shown in Figure 4. In Figure 4, the horizontal-axis indicates the elapsed time, and the vertical-axis indicates the emitter current IE of the transistor 13. Curves I, II, and III respectively show the emitter current variation for when the capacitance of the capacitor 19 is 3 pF, 1 pF, or 0 pF. As clearly seen from the curves I, II, and III, as the capacitance of the capacitor 19 is increased, the peak amplitude of the emitter curent $I_E$ is increased. Furthermore, the rise-time of the emitter current $I_E$ decreases, and the rising characteristic becomes one in which the rise is very sharp. In Figure 4, a time t0 indicates the time when the input logic signal IN becomes 1.3 volts, and the times ta, tb, and tc respectively show the times when the emitter current $I_E$ shown by the curves I, II, and III reaches a certain current value $I_A$. The time between the times t0 and ta $\overline{(t0\ ta)}$, the time between the times t0 and tb $\overline{(t0\ tb)}$, and the time between the times t0 and tc $\overline{(t0\ tc)}$ respectively are proportional to the turn-on-time in each of the curves I, II, and III. That is,

$$\overline{t0\ ta} < \overline{t0\ tb} < \overline{t0\ tc},$$

and therefore, the turn-on-time is inversely proportional to the increase in the capacitance, and decreases.

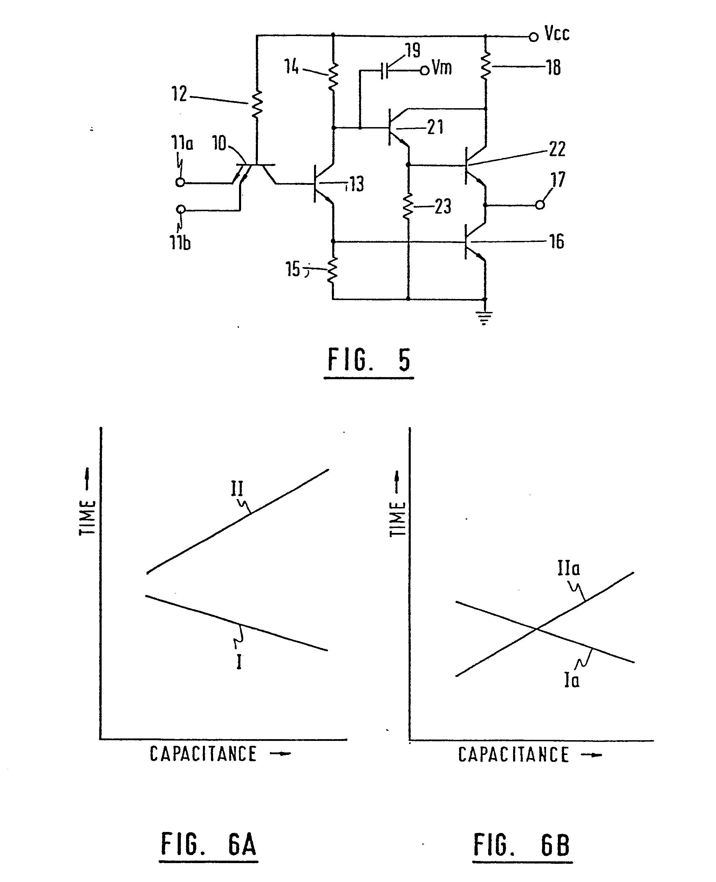

A second embodiment of a circuit of the present invention will now be described in conjunction with Figure 5. In Figure 5, those parts which are the same as those corresponding parts in Figure 1 are designated by the like reference numerals, and their description will be omitted. This embodiment of the invention comprises a totem pole type TTL circuit. One terminal of the capacitor 19 is connected to the collector of the transistor 13, and the other terminal is connected to a voltage source Vm. The base and the collector of a transistor 21 are respectively connected to the collector of the transistor 13 and the resistor 18. The base of a transistor 22 is connected to the emitter of the transistor 21 as well as to ground through a resistor 23. The emitter and the collector of the transistor 22 are respectively connected to the collector of the transistor 16 and the collector of the transistor 21.

According to the circuit of the present embodiment, when the phase-splitting transistor 13 is turned OFF, the collector of the transistor 13 charges the stray capacitance of the collector through the resistor 14. Hence, the rise-time of the collector potential of the transistor 13 is determined by a time constant formed by the resistor 14 and the capacitor 19. The rise in the collector potential of the transistor 13 is visible at the output side, after being shifted of its level by the two transistors 21 and 22. By providing the capacitor 19, the turn-on-time tpHL is reduced as shown by a curve I of Figure 6A, for the same reason as that described above for the first embodiment. However, since the capacitor 19 is provided, the turn-off-time tpLH becomes long as shown by a curve II of Figure 6A, because the time constant determined by the resistor 14 and the capacitor 19 is increased.

As shown by the curves I and II of Figure 6A, hazards can be decreased by letting a difference exist between the turn-on-time tpHL and the turn-off-time tpLH.

Furthermore, due to the recent developments in the processing techniques, the stray capacitance of recent transistors is small, and therefore, a circuit can be obtained in which the turn-off-time tpLH is shorter than the turn-on-time tpHL. Hence, when the circuit of the present invention is applied to this type of a circuit, and the capacitance of the capacitor 19 is selected to a suitable value, a characteristic such as that shown in Figure 6B can be obtained in which the turn-on-time characteristic curve Ia and the turn-off time characteristic curve IIa intersect at one point. Accordingly, the turn-on-time tpHL and the turn-off-time tpLH can be selected so that they are equal.

## Claims

1. A transistor-transistor logic circuit comprising:

an input means (10) for receiving an input logic signal;

a phase-splitting transistor (13) having its base connected to the input means (10) and its collector connected for receiving a power source potential (Vcc) of the circuit via a resistor (14), and

an output transistor (16) having its base connected to the emitter of said phase-splitting transistor (13), and being arranged to supply on its collector an output logic signal responsive to said input logic signal;

characterised in that the circuit further comprises a capacitive element (19) having one terminal connected to the collector of said phase-splitting transistor (13), and another terminal connected to a point of predetermined potential, operable to reduce the turn-on-time of the output transistor (16).

2. A circuit as claimed in claim 1, in which said predetermined potential is the power source potential (Vcc) of the circuit.

3. A circuit as claimed in claim 1, in which said predetermined potential is ground potential.

4. A circuit as claimed in claim 1, in which said predetermined potential is an intermediate potential (Vm) between the power source potential (Vcc) of the circuit and ground potential.

## Revendications

1. Circuit logique du type transistor-transistor comprenant:

— un dispositif d'entrée (10) destiné à recevoir un signal logique d'entrée;

— un transistor déphaseur (13) connecté par sa base au dispositif d'entrée (10) et dont le collecteur est connecté pour recevoir le potentiel d'une source d'alimentation (Vcc) du circuit à travers une résistance (14); et

— un transistor de sortie (16) relié par sa base à l'émetteur du transistor déphaseur (13) et agencé pour fournir sur son collecteur un signal logique de sortie fonction du signal logique d'entrée,

— qui est caractérisé en ce qu'il comprend en plus en élément capacitif (19) connecté par une borne au collecteur du transistor déphaseur (13) et par l'autre borne à un point à potentiel prédéterminé, en vue de la réduction du temps d'enclenchement ou de passage de l'état bloqué à l'état conducteur du transistor de sortie (16).

2. Circuit selon la revendication 1, dans lequel le potentiel prédéterminé est le potentiel de la source d'alimentation (Vcc) du circuit.

3. Circuit selon la revendication 1, dans lequel le potentiel prédéterminé est le potentiel de la masse.

4. Circuit selon la revendication 1, dans lequel le potentiel prédéterminé est un potentiel intermédiaire (Vm) entre le potentiel de la source d'alimentation (Vcc) du circuit et le potentiel de la masse.

**Patentansprüche**

1. Logische Transistor-Transistor-Schaltung mit:

einer Eingangsschaltung (10) zum Empfang eines logischen Eingangssignals,

einem phasenteilenden Transistor (13), dessen Basis mit der Eingangseinrichtung (10) verbunden ist und dessen Kollektor zum Empfang eines Potentials (Vcc) einer Energiequelle der Schaltung über einen Widerstand (14) verbunden ist, und

einem Ausgangstransistor (16), dessen Basis mit dem Emitter des genannten phasenteilenden Transistors (13) verbunden ist, und der so angeordnet ist, daß an seinem Kollektor ein logisches Ausgangssignal geliefert wird, welches auf das logische Eingangssignal anspricht, dadurch gekennzeichnet,

daß die Schaltung ferner ein kapazitives Element (19) enthält, dessen einer Anschluß mit dem Kollektor des genannten phasenteilenden Transistors (13) und dessen anderer Anschluß mit einem Punkt vorbestimmten Potentials verbunden ist, und welches im Betrieb die Einschaltzeit des Ausgangstransistors (16) reduzieren kann.

2. Schaltung nach Anspruch 1, bei welcher das genannte vorbestimmte Potential das Energiequellenpotential (Vcc) der Schaltung ist.

3. Schaltung nach Anspruch 1, bei welcher das vorbestimmte Potential Erdpotentiel ist.

4. Schaltung nach Anspruch 1, bei welcher das vorbestimmte Potential ein Zwischenpotential (Vm) zwischen dem Energiequellenpotential (Vcc) der Schaltung und Erdpotential ist.

FIG. 1

FIG. 2A

FIG. 2B

FIG. 3

FIG. 4

FIG. 5

FIG. 6A

FIG. 6B